(19) Europäisches Patentamt / European Patent Office / Office européen des brevets

(11) **EP 2 705 587 B1**

(12) **FASCICULE DE BREVET EUROPEEN**

(45) Date de publication et mention
de la délivrance du brevet:
**09.09.2015 Bulletin 2015/37**

(51) Int Cl.:
***H02H 9/00*** *(2006.01)*   ***H02H 3/02*** *(2006.01)*
***H02H 7/04*** *(2006.01)*   ***H01H 7/16*** *(2006.01)*

(21) Numéro de dépôt: **12719659.0**

(22) Date de dépôt: **30.04.2012**

(86) Numéro de dépôt international:
**PCT/EP2012/057933**

(87) Numéro de publication internationale:
**WO 2012/150225 (08.11.2012 Gazette 2012/45)**

(54) **PROCEDE DE COMMANDE D'UN APPAREIL D'INTERRUPTION DE COURANT DANS UN RESEAU ELECTRIQUE HAUTE TENSION**

VERFAHREN ZUR STEUERUNG EINER STROMUNTERBRECHUNGSVORRICHTUNG IN EINEM HOCHSPANNUNGSNETZ

METHOD FOR CONTROLLING A CURRENT-INTERRUPTING DEVICE IN A HIGH-VOLTAGE ELECTRICAL NETWORK

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **03.05.2011  FR 1153779**

(43) Date de publication de la demande:
**12.03.2014   Bulletin 2014/11**

(73) Titulaire: **ALSTOM Technology Ltd
5400 Baden (CH)**

(72) Inventeurs:
• **JUNG, Thierry**
  **F-69002 Lyon (FR)**
• **LIU, Tian**
  **F-69006 Lyon (FR)**
• **SIGUERDIDJANE, Houria**
  **F-91440 Bures sur Yvette (FR)**
• **PETIT, Marc**
  **F-91400 Orsay (FR)**

(74) Mandataire: **Ahner, Philippe et al
BREVALEX
95, rue d'Amsterdam
75378 Paris Cedex 8 (FR)**

(56) Documents cités:
**EP-A1- 0 222 727     EP-A1- 2 141 780
WO-A1-80/01516     DE-A1- 19 641 116
FR-A1- 2 140 529     US-A1- 2010 039 737**

## Description

### DOMAINE TECHNIQUE

L'invention concerne un procédé de commande d'un appareil d'interruption de courant dans un réseau électrique haute tension.

Dans la suite, pour simplifier la description, on considère un appareil d'interruption de courant de type disjoncteur.

### ÉTAT DE LA TECHNIQUE ANTÉRIEURE

L'invention concerne un procédé de réduction des courants d'appel liés à la manoeuvre d'un appareil d'interruption de courant du transformateur de puissance dans un réseau électrique haute tension, procédé permettant de déterminer de manière optimale les instants de commutation de cet appareil.

En effet, les manoeuvres des appareils d'interruption de courant, tels que les disjoncteurs, dans un réseau électrique haute tension sont sources de perturbations, telle que des surtensions et des courants d'appel. De tels phénomènes sont liés notamment à la complexité des réseaux de transport d'énergie et de leurs interconnexions. Pour contrôler les transitoires liés à de telles manoeuvres, il existe des solutions telles que l'utilisation de résistances et d'inductances de pré-insertion pour l'ouverture et/ou la fermeture de ces appareils mais la solution la plus efficace est obtenue par une manoeuvre dite « contrôlée », qui permet de choisir un instant optimum d'ouverture ou de fermeture en fonction de la tension instantanée du réseau.

La mise hors tension d'un transformateur de puissance à vide génère peu de transitoires. Toutefois une fermeture non contrôlée peut générer des courants d'appel importants, susceptibles d'atteindre le niveau des courants de défaut des transformateurs. De tels courants contraignent l'enroulement, créent des tensions temporaires sévères qui dégradent la qualité de la fourniture électrique et provoquent des fonctionnements intempestifs par suite des déséquilibres du courant de neutre. De plus, les contraintes électrodynamiques exercées dans les enroulements du transformateur entrainent une réduction de la durée de vie de ces enroulements.

Pour résoudre un tel problème, une solution de l'art connu décrite dans le document référencé [1] en fin de description consiste en la mise en oeuvre d'un algorithme calculant l'instant optimal de fermeture. Cet algorithme nécessite la connaissance du niveau du flux rémanent, via la connaissance des tensions aux bornes du transformateur. Les transformateurs de tension utilisés dans les postes à haute tension sont très souvent du type transformateur capacitif de tension, en raison de leur coût. Or, les performances en régime transitoire de tels transformateurs sont très peu adaptées à ce type d'application. C'est pourquoi les méthodes usuelles pour faire cette estimation du flux rémanent mettent en oeuvre des transformateurs de tension spécifiques.

La valeur du flux magnétique est généralement obtenue en intégrant la tension aux bornes du transformateur de puissance. Le flux rémanent nécessite que cette intégration se poursuive au-delà de l'instant de mise hors tension du transformateur de puissance, pendant un temps suffisamment long pour permettre au flux d'atteindre sa valeur d'équilibre, laquelle est généralement différente de celle qu'il avait à l'instant de coupure. Or, pendant cette durée, la tension délivrée par le transformateur capacitif de tension va être profondément altérée par son propre régime transitoire. La difficulté consiste à éliminer l'influence de ce régime transitoire. Les méthodes de fermeture synchrone de l'art connu ne traitent pas ce problème, et font appel à des capteurs de tension spécifiques.

Le document référencé [2] en fin de description décrit la manoeuvre contrôlée de transformateurs de puissance tenant compte du flux magnétique rémanent. Cette manoeuvre contrôlée, consiste à choisir l'instant approprié de mise sous tension de chacune des phases du transformateur en tenant compte du flux rémanent. Ce document impose d'utiliser des capteurs spécifiques, qui présentent un coût supplémentaire. Par ailleurs, certains types de transformateurs de puissance ne peuvent pas être équipés de tels capteurs.

Le document DE19641116A1 divulgue un procédé de commande d'un appareil d'interruption de courant conforme au préambule de la revendication 1.

La présente invention a pour l'objet de résoudre ces problèmes en proposant un procédé permettant l'estimation du flux rémanent d'un transformateur de puissance à partir de la mesure de tension délivrée par un transformateur capacitif de tension.

### EXPOSÉ DE L'INVENTION

L'invention concerne un procédé de commande d'un appareil d'interruption de courant pour réaliser la mise hors tension d'un transformateur de puissance dans un réseau électrique haute tension, dans lequel on définit cette mise hors tension en analysant le flux rémanent de ce transformateur de puissance, caractérisé en ce qu'il comprend les étapes suivantes:

- on détermine l'instant optimum de commutation de l'appareil d'interruption du courant à l'aide d'une valeur estimée du flux rémanent de ce transformateur de puissance à partir de mesures de tension délivrées par un moins un transformateur capacitif de tension connecté entre la sortie de l'appareil d'interruption du courant et l'entrée du transformateur de puissance en réalisant successivement:
- la détermination de la fonction de transfert de ce transformateur capacitif de tension;
- la détermination de la fonction de transfert pseudo-inverse;
- on réalise la mise hors tension de ce transformateur de puissance, avec en temps réel :

- mémorisation de la tension de sortie du transformateur capacitif de tension,
- traitement numérique via une fonction de transfert pseudo inverse,
- intégration du signal ainsi corrigé pour obtenir la valeur du flux rémanent.

Avantageusement, la détermination de la fonction de transfert du transformateur capacitif de tension est obtenue à partir du circuit électrique de celui-ci.

Avantageusement, la détermination de la fonction de transfert du transformateur capacitif de tension est obtenue par identification des pôles et des zéros en utilisant la réponse indicielle d'un filtre équivalent.

Avantageusement, la détermination de la fonction pseudo-inverse du transformateur capacitif de tension se fait avec insertion d'un filtre passe-bas.

## BRÈVE DESCRIPTION DES DESSINS

La figure 1 représente un schéma illustrant, dans un système de l'art connu, les manoeuvres contrôlées d'un disjoncteur dans un réseau haute tension,

Les figures 2 et 3 illustrent des circuits équivalents d'un transformateur capacitif de tension monophasé avec un circuit anti-ferrorésonance,

La figure 4 illustre la procédure de reconstitution du signal d'entrée d'un transformateur capacitif de tension,

La figure 5 illustre le signal de tension reconstitué après un traitement par pseudo-fonction de transfert inverse, selon l'invention.

La figure 6 illustre la correction géométrique du signal de tension ainsi reconstitué de la figure 5 par rapport à la tension réelle.

La figure 7 illustre le flux réel (trait plein) et le flux estimé (pointillés) à la mise hors tension du transformateur de puissance.

La figure 8 illustre le schéma électrique d'un système mettant en oeuvre le procédé de l'invention.

## EXPOSÉ DÉTAILLÉ DE MODES DE RÉALISATION PARTICULIERS

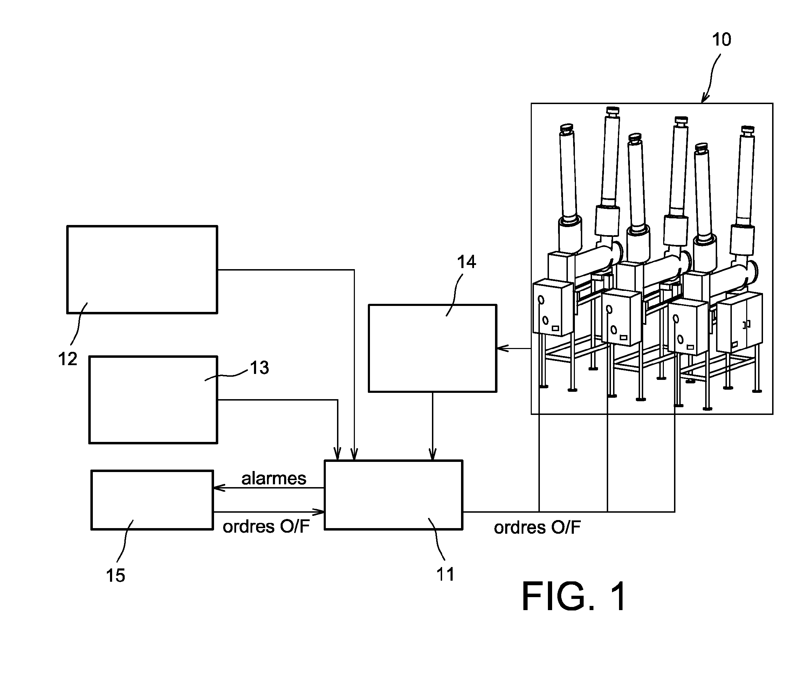

La figure 1 représente un schéma illustrant, dans un système de l'art connu, les manoeuvres contrôlées d'un disjoncteur 10 à l'aide d'un contrôleur 11 qui reçoit différentes informations :

- des informations réseau 12, telles que :

    • tension référence,
    • courant,
    • mise à la terre,

- des informations de réglage 13, telles que :

    • applications,
    • durées,
    • compensation,

- des informations 14 relatives au disjoncteur 10, telles que :

    • température,
    • pression,
    • tension auxiliaire,
    • pression auxiliaire,

et qui est relié à une commande de contrôle 15, en lui envoyant des signaux d'alarme, et en recevant de celle-ci des ordres d'ouverture/de fermeture (O/F) de ce disjoncteur 10.

De nombreuses applications nécessitent de connaître la valeur du flux rémanent du transformateur de puissance, spécialement dans le cas d'une commutation contrôlée d'un transformateur de puissance non chargé. L'incertitude concernant le flux rémanent peut réduire de manière significative la performance de commutation contrôlée. L'invention met en évidence l'importance d'identifier le flux rémanent par son influence sur les formes d'onde afin d'éviter toute dégradation de l'instant de fermeture. Le flux rémanent dépend de l'hystérésis du matériau magnétique, de l'instant de désexcitation et des conditions de fonctionnement du système de puissance à cet instant. Il ne peut être obtenu directement par une mesure, mais doit être dérivé à partir d'un signal plus facilement accessible tel que la tension aux bornes du transformateur. La mesure de cette tension et son intégration sont réalisées sur une courte fenêtre temporelle entourant l'instant de désexcitation. Les transformateurs capacitifs de tension (CVT), qui sont utilisés comme capteurs de tension, introduisent des erreurs transitoires importantes qui doivent être prise en compte. La plupart des études de commutation contrôlées du transformateur de puissance négligent les erreurs intrinsèques de ces transformateurs capacitifs de tension.

En utilisant la tension secondaire d'un transformateur capacitif de tension, on doit reconstituer la forme d'onde de la tension primaire et en considérant le flux rémanent, fixer une valeur dans l'algorithme en charge d'évaluer l'instant de fermeture optimal.

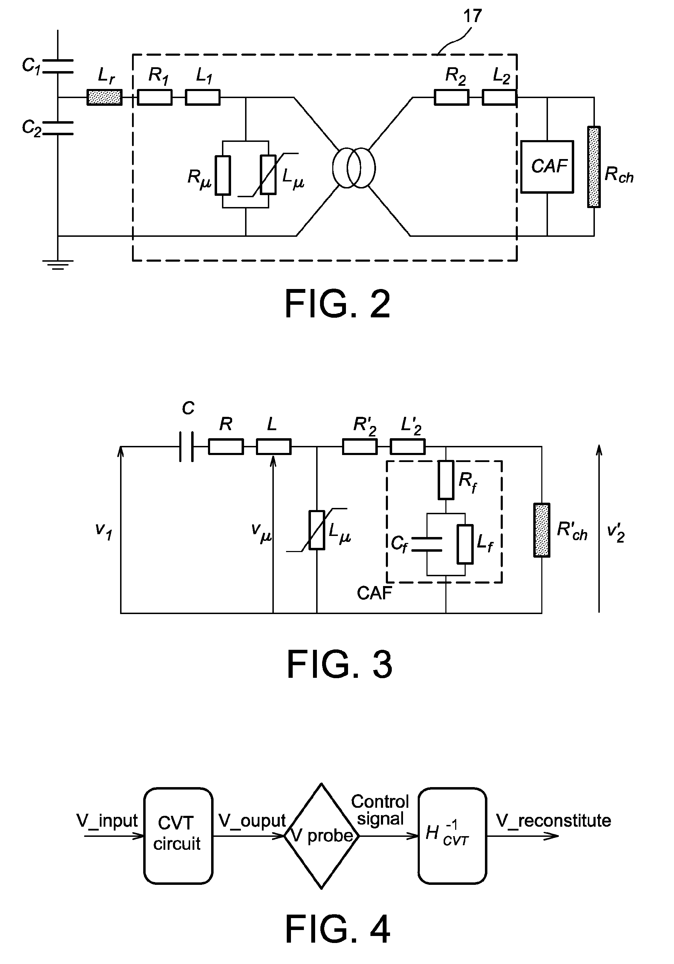

Les caractéristiques d'un transformateur capacitif de tension sont illustrées sur la figure 2, avec un transformateur de type inductif abaisseur 17. L'interaction des capacités C1, C2 utilisées comme diviseur capacitif, avec l'inductance d'ajustement Lf et la branche de l'inductance de magnétisation non linéaire du transformateur Ln peut générer un phénomène particulier appelé ferro-résonance. Pour surmonter ce phénomène, les fabricants associent au transformateur capacitif de tension un circuit oscillant CAF (circuit anti-ferrorésonance) qui est connecté à l'enroulement secondaire du transformateur. Ce modèle ainsi illustré sur la figure 2 peut être simplifié comme illustré sur la figure 3. La capacité équivalente C est égale à la somme des capacités C1 et de C2. L'inductance L est la somme de l'inductance d'ajustement LF et des inductances d'enroulement du transformateur inductif. La résistance R est la résistance du primaire. L'inductance de magnétisation Lμ est alors située en zone linéaire, en considérant les niveaux de tension du transformateur. Elle peut être négligée par rapport aux autres composants du transformateur capacitif de tension. Le transformateur capacitif de tension peut être considéré comme un filtre passe bande avec une fonction de transfert du type :

$$Hcvt = \frac{V'_2(p)}{V_1(p)} = \frac{\sum\limits_{i=1}^{n} a_i\, p^i}{\sum\limits_{i=o}^{m} b_i\, p^i}$$

avec m≥2, n≥1, m-n≥1

La figure 4 représente la procédure globale de la méthode de reconstitution du signal de tension à l'entrée du transformateur capacitif de tension. On considère la tension du côté du transformateur de puissance à l'ouverture comme signal d'entrée V_input. La mesure réalisée est sur une courte fenêtre entourant l'instant de mise hors tension. Le traitement est différé en « pseudo-temps réel ». Le signal de sortie V_output du transformateur capacitif de tension est mesuré (V probe) et traité par la pseudo-fonction de transfert inverse $H_{CVT}^{-1}$ pour obtenir le signal V_reconstitute.

$$H_{cvt}^{-1} = \frac{T(p)}{Hcvt} = \frac{\sum\limits_{i=o}^{m} a_i\, p^i}{\sum\limits_{i=1}^{m} b_i\, p^i}$$

où T(p) désigne un filtre passe-bas d'ordre m-n

On ne peut pas effectuer une inversion directe du fait que le degré relatif de la fonction de transfert $H_{CVT}$ est supérieur ou égal à 1. Le filtre passe-bas ainsi réalisé est sélectionné en fonction de la bande passante du transformateur capacitif de tension. La fréquence de coupure de ce filtre est largement plus grande que la borne supérieure de la bande passante du transformateur capacitif de tension et le gain du filtre est à 1.

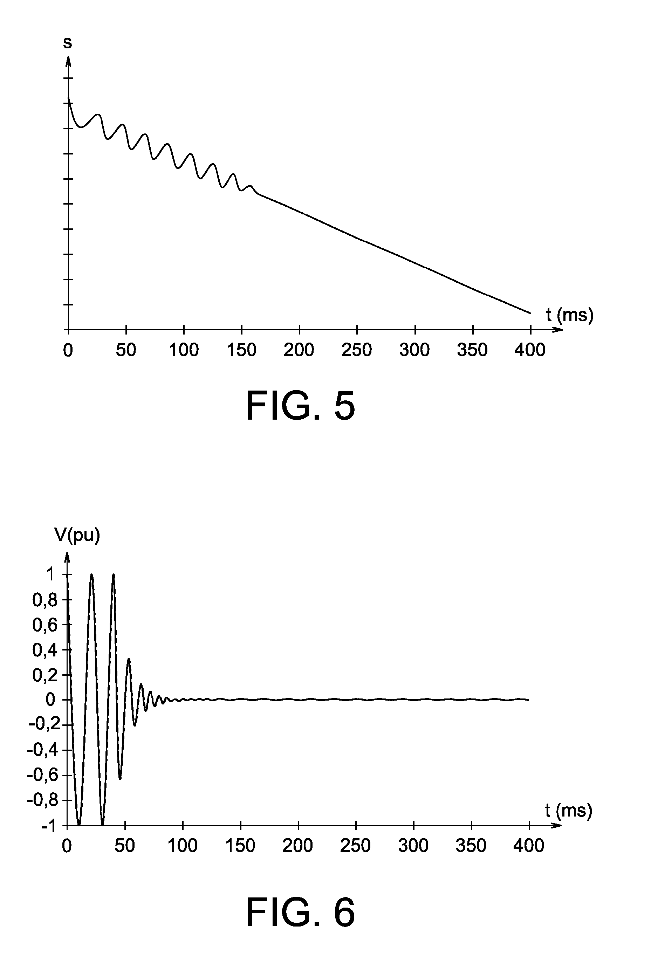

La figure 5 illustre le signal de tension reconstitué s après le traitement par pseudo-fonction de transfert inverse $H_{CVT}^{-1}$. Mais, la présence de décalages (offset) dans la fenêtre de mesure peut entrainer une divergence du signal reconstitué à cause de l'intégrateur en basse fréquences $\frac{a_0}{b_1 p}$.

La figure 6 illustre le signal de tension reconstitué et corrigé en pointillés avec la tension transformateur réelle en trait continu. En utilisant une compensation géométrique à l'aide d'une rampe, cette divergence peut être facilement corrigée et le signal obtenu correspond finalement au signal de tension du côté du transformateur de puissance avec une très grande exactitude.

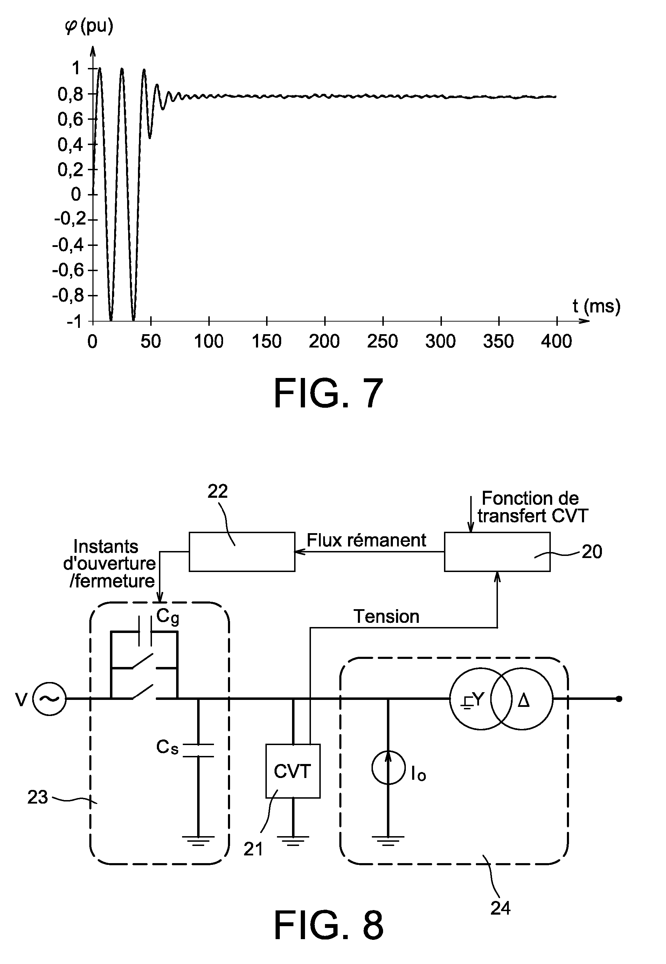

La figure 7 illustre le flux à la mise hors tension du transformateur de puissance, avec le flux réel (trait continu) et le flux estimé (pointillés).

On intègre alors le signal reconstitué et corrigé pour obtenir le signal flux à l'ouverture du transformateur de puissance.

La figure 8 illustre un système mettant en oeuvre le procédé de l'invention. Ce système comprend un calculateur 20 qui reçoit une tension d'un transformateur capacitif de tension 21 et la fonction de transfert de ce transformateur capacitif de tension, et qui délivre la valeur du flux rémanent à un contrôleur 22 qui détermine l'instant d'ouverture/fermeture d'un disjoncteur 23. Le transformateur capacitif de tension est connecté entre la sortie du disjoncteur 23 et l'entrée d'un transformateur de puissance 24. V représente la source ou le réseau. Le procédé de l'invention réalise ainsi successivement :

-   la détermination de la fonction de transfert du transformateur capacitif de tension :

    •   à partir du circuit électrique de ce transformateur capacitif de tension, si celui-ci est fourni ;

    •   ou par identification des pôles et des zéros en utilisant la réponse indicielle d'un filtre équivalent ;

-   la détermination de la fonction de transfert pseudo-inverse : L'inversion de cette fonction de transfert n'est pas directe. Pour respecter les conditions de stabilité imposées par l'opération d'inversion, il faut insérer un filtre passe-bas, dont le choix est fait de façon à ce qu'il ne contribue pas à la réponse transitoire équivalente du transformateur capacitif de tension.

-   puis, en temps réel, à la mise hors tension du transformateur de puissance, avec :

    •   mémorisation de la tension de sortie du transformateur capacitif de tension,

    •   traitement numérique via une fonction de transfert pseudo inverse,

    •   intégration du signal corrigé pour avoir la valeur du flux rémanent.

Le temps de calcul est compatible avec le temps de cycle de réenclenchement. Il s'agit donc bien de calculs « en temps réel ».

**Références**

(1) « Manoeuvre contrôlée de transformateurs à vide de Esteban Portales et André Mercier (Electra, n°212, Février 2004).

(2) « Manoeuvre contrôlée de transformateur tenant compte du flux magnétique rémanent - étude de cas réel » de A. Mercier, E. Portales, Y. Filion, et A. Salibi (cigré, 13-201, session 2002).

**Revendications**

**1.** Procédé de commande d'un appareil d'interruption de courant (23) pour réaliser la mise hors tension d'un transformateur de puissance (24) dans un réseau électrique haute tension dans lequel on définit cette mise hors tension en analysant le flux rémanent de ce transformateur de puissance (24), **caractérisé en ce qu'**il comprend les étapes suivantes :

- on détermine l'instant optimum de commutation de l'appareil d'interruption du courant (23) à l'aide d'une valeur estimée du flux rémanent de ce transformateur de puissance (24) à partir de mesures de tension délivrées par un moins un transformateur capacitif de tension (21) connecté entre la sortie de l'appareil d'interruption du courant (23) et l'entrée du transformateur de puissance (24) en réalisant successivement :

• la détermination de la fonction de transfert de ce transformateur capacitif de tension (21) ;
• la détermination de la fonction de transfert pseudo-inverse ;

- on réalise la mise hors tension de ce transformateur de puissance (24), avec en temps réel :

• mémorisation de la tension de sortie du transformateur capacitif de tension (21),
• traitement numérique via une fonction de transfert pseudo inverse,
• intégration du signal ainsi corrigé pour obtenir la valeur du flux rémanent.

**2.** Procédé selon la revendication 1, dans lequel la détermination de la fonction de transfert du transformateur capacitif de tension (21) est obtenue à partir du circuit électrique de celui-ci.

**3.** Procédé selon la revendication 1, dans lequel la détermination de la fonction de transfert du transformateur capacitif de tension (21) est obtenue par identification des pôles et des zéros en utilisant la réponse indicielle d'un filtre équivalent.

**4.** Procédé selon la revendication 1, dans lequel la détermination de la fonction pseudo-inverse du transformateur capacitif de tension (21) se fait avec insertion d'un filtre passe-bas.

**Patentansprüche**

**1.** Verfahren zur Steuerung eines Stromunterbrechungsgeräts (23) zum Realisieren der Spannungsabschaltung eines Leistungstransformators (24) in einem elektrischen Hochspannungsnetz, wobei man diese Spannungsabschaltung definiert, indem man den remanenten Fluss dieses Leistungstransformators (24) analysiert, **dadurch gekennzeichnet, dass** es die folgenden Schritte umfasst:

- man bestimmt den optimalen Umschaltzeitpunkt des Stromunterbrechungsgeräts (23) mithilfe eines geschätzten Werts des remanenten Flusses dieses Leistungstransformators (24) ausgehend von Spannungsmessungen, die von wenigstens einem kapazitiven Spannungstransformator (21) geliefert werden, der zwischen dem Ausgang des Stromunterbrechungsgeräts (23) und dem Eingang des Leistungstransformators (24) angeschlossen ist, indem man nacheinander folgende Schritte durchführt:

• die Bestimmung der Transferfunktion dieses kapazitiven Spannungstransformators (21);
• Die Bestimmung der pseudo-inversen Transferfunktion;

- man realisiert die Spannungsabschaltung dieses Leistungstransformators (24), mit folgenden Schritten in Echtzeit:

• Speicherung der Ausgangsspannung des kapazitiven Spannungstransformators (21),
• digitale Verarbeitung mittels einer pseudo-inversen Transferfunktion,
• Integration des derart korrigierten Signals, um den Wert des remanenten Flusses zu erhalten.

**2.** Verfahren nach Anspruch 1, bei dem die Bestimmung der Transferfunktion des kapazitiven Spannungstransformators (21) ausgehend von der elektrischen Schaltung desselben erhalten wird.

**3.** Verfahren nach Anspruch 1, bei dem die Bestimmung der Transferfunktion des kapazitiven Spannungstransformators (21) durch Identifizierung der Pole und der Nullstellen erhalten wird, wobei man die Sprungantwort eines äquivalenten Filters verwendet.

4. Verfahren nach Anspruch 1, bei dem die Bestimmung der pseudo-inversen Funktion des kapazitiven Spannungstransformators (21) mit Einfügen eines Tiefpassfilters erfolgt.


**Claims**

1. A method of controlling switchgear (23) for disconnecting a power transformer (24) in a high-voltage electric network, wherein this disconnecting is defined in analyzing the remanent flux of said power transformer (24),
   **characterized in that** it includes the following steps:

   - determining the optimum switchgear switching instant, with an estimated value of the remanent flux of said power transformer (24) from voltage measurements delivered by at least one capacitive voltage transformer (21) connected between the switchgear (23) output and the power transformer (24) input in successively realizing:

      - determining the transfer function of the capacitive voltage transformer (21);
      - determining the pseudo-inverse transfer function;

   - disconnecting the power transformer (24), with in real time:

      · storing of the voltage output of the capacitive voltage transformer (21);
      · digital processing via a pseudo-inverse transfer function; and
      · integration of the so corrected signal in order to acquire the value of the remanent flux.

2. A method according to claim 1, wherein the transfer function of the capacitive voltage transformer (21) is determined from the electrical circuit of said transformer.

3. A method according to claim 1, wherein the transfer function of the capacitive voltage transformer (21) is determined by identifying poles and zeros by using the step response of an equivalent filter.

4. A method according to claim 1, wherein the pseudo-inverse function of the capacitive voltage transformer (21) is determined by insertion of a low-pass filter.

FIG. 1

FIG. 2

FIG. 3

FIG. 4

FIG. 5

FIG. 6

FIG. 7

FIG. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 19641116 A1

**Littérature non-brevet citée dans la description**

- **ESTEBAN PORTALES ; ANDRÉ MERCIER.** *Manoeuvre contrôlée de transformateurs à vide,* Février 2004

- **A. MERCIER ; E. PORTALES ; Y. FILION ; A. SALIBI.** *Manoeuvre contrôlée de transformateur tenant compte du flux magnétique rémanent - étude de cas réel,* 2002